(19) Europäisches Patentamt
European Patent Office
Office européen des brevets

(11) **EP 2 075 573 A1**

(12) **EUROPEAN PATENT APPLICATION**

(43) Date of publication:
**01.07.2009 Bulletin 2009/27**

(51) Int Cl.:
*G01N 24/08* (2006.01)    *G01R 33/44* (2006.01)
*G01N 22/00* (2006.01)    *G01V 3/14* (2006.01)

(21) Application number: **08172081.5**

(22) Date of filing: **18.12.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **28.12.2007 US 965968**

(71) Applicant: **GE Homeland Protection, Inc.
Newark, CA 94560-1012 (US)**

(72) Inventors:
• **Magnuson, Erik Edmund
Cardiff, CA 92007 (US)**

• **Kumar, Sankaran
San Marcos, CA 92078 (US)**
• **Czipott, Peter Victor
San Diego, CA 92126 (US)**

(74) Representative: **Illingworth-Law, William
Illingworth
GE International Inc.
London Patent Operation
15 John Adam Street
London
WC2N 6LU (GB)**

(54) **Systems and method for classifying a substance**

(57)    A classification system (50) is provided. The classification system (50) includes a resonance classification system (52), an electromagnetic classification system (100) including an antenna (10) and a measurement device (112) communicatively coupled to the antenna, the measurement device generating a signal representative of a measurement of a reflected electromagnetic signal, and a control system (54) operatively coupled to the resonance classification system and the electromag-netic classification system, the control system configured to output a classification of a substance based at least partially on a reflection coefficient determined using the signal generated by the measurement device.

FIG. 2

## Description

FIELD OF THE INVENTION

The field of the invention relates generally to systems for classifying a substance and, more particularly, to an electromagnetic classification system for classifying a substance.

BACKGROUND OF THE INVENTION

At least some known classification systems use electromagnetic signals to facilitate classifying a substance. One known classification system is a dielectrometry monitoring apparatus that three-dimensionally profiles and color images material contents of an article that is carried through an interrogation region. The apparatus includes a stationary, collimated, microwave transmitter/receiver antennae array and associated electronics for measuring the dielectric constant of the material contents to produce data representative of the dielectric material configuration and contents of the article. High-speed GaAs gates, switching devices, and microstrip delay lines are used to perform timed, depth-wise sampling of data regarding the dielectric constant material characteristics. As such, timed microwave pulses are directed towards the article to determine the dielectric constant of material within the article. The system compares the dielectric constant data to predefined criteria to determine whether the data profile of the material is indicative of any of a variety of contraband or hazardous conditions.

Another known classification system includes an interrogation region through which a target that is to be screened passes and a transmitter/receiver array that operates adjacent the interrogation region for illuminating the target with a pulsed microwave beam. As such, the microwave beam is time-dependent. The system monitors a dielectric response received from the target, and includes electronics that produce output data that is interpretable to identify the presence of contraband associated with the illuminated target based on the dielectric response of the target.

Yet another known classification system facilitates classify liquids based on measured dielectric properties of a liquid by transmitting an electromagnetic signal, typically at microwave frequencies, at the liquid. However, using microwave dielectrometry alone may cause a relatively large number of false alarms and/or false negatives. Such dielectrometers discriminate between liquids by generally classifying them on the basis of high, or generally benign, and low, or generally hazardous, dielectric constants, which may generate false alarms and/or false negatives. For example, cooking oil, generally not considered a hazardous material, has a low dielectric constant may be classified as hazardous while a mixture of hydrogen peroxide and acetone, considered an explosive material, may be classified as safe based on its high dielectric constant. Some known improvements to such classification systems have been made by using an imaginary part of the dielectric constant, or the "loss tangent". However, dielectrometry, when used by itself, has other limitations in addition to that discussed above, such as calibration of such a system for the shape, size, and/or type of material of the container having the liquid therein.

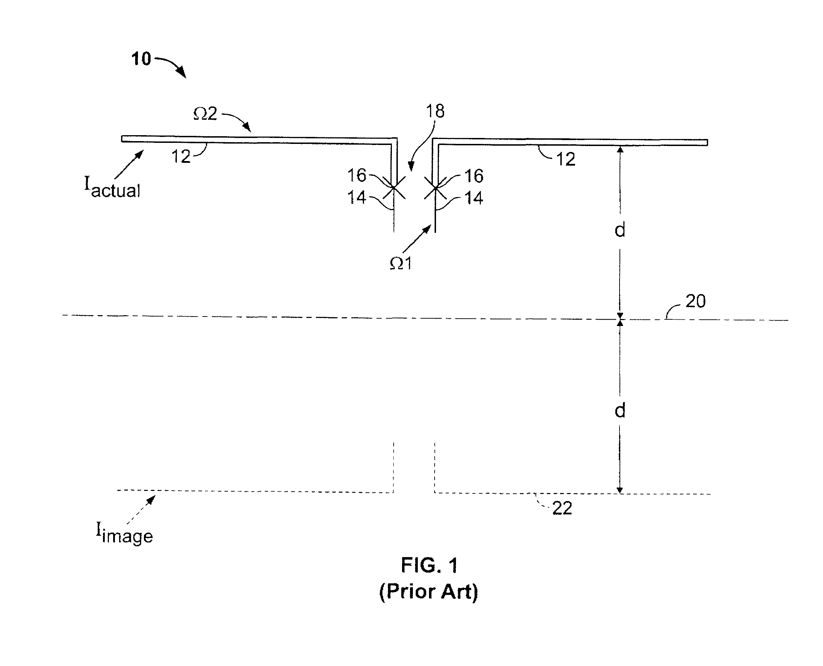

A known dipole antenna 10 is shown in Figure 1. As used herein, the term "dipole antenna" refers to an antenna that includes an electrically conducting wire or rod 12 that is one-half the length of the maximum desired wavelength, or $\lambda/2$. As is known, rod 12 of dipole antenna 10 is split at the center with an insulator, and each end of the antenna at the center is connected to a feed line 14, for example, via a balun to a coaxial cable and/or transmission line. Dipole antenna 10 is center-fed driven to transmit and/or receive radio frequency energy. A feedpoint 16 is defined where feed line 14 is coupled to dipole antenna rods 12. A gap 18 is defined at feedpoint 16 and between rods 12 of antenna 10. At feedpoint 16, feed line 14 has a predetermined impedance $\Omega 1$ and antenna 10 has an impedance $\Omega 2$ such that, in free space, impedance $\Omega 1$ is at resonance when antenna 10 is horizontally polarized. As used herein, the term "free space" refers to a location that is infinitely remote from the ground or Earth's surface. Further, as used herein, the term "impedance" refers to a total opposition (i.e., resistance and/or reactance) a circuit offers to a flow of alternating current.

When a flat, perfect conductor 20 is positioned near antenna 10 and spaced a distance *d* from antenna 10, the interaction between antenna 10 and conductor 20 can be modeled by assuming an image antenna 22 is spaced distance *d* from an opposite side of conductor 20 as antenna 10. Image antenna 22 is a replacement for a ground plane conducting surface generated by the ground proximate to antenna 10. The current $I_{image}$ flowing in image antenna 22 is equal and opposite the current $I_{actual}$ of antenna 10.

Other known classification systems use magnetic resonance and/or quadrupole resonance to classify objects and/or substances. Such systems may be referred to herein as "resonance classification systems," and/or variations thereof. One known type of resonance classification system is a nuclear magnetic resonance (NMR) system. The NMR system uses the quantum mechanical magnetic properties of an atom's nucleus and the nuclear magnetic resonance to study molecules in a material. For example, at least some known NMR systems examine magnetic nuclei by aligning the nuclei of a substance using an applied constant magnetic field and disturbing the resulting alignment of the nuclei using an alternating magnetic field. The response of the nuclei to the alternating electric field is used to determine a resonant absorption of a material that is detected by the NMR system. Different atoms within a molecule resonate at different frequencies at a given field strength and, as such, the observation of the resonance frequencies of a molecule allows a user to discover structural information about the molecule. Furthermore, the time relaxation characteristics of the NMR response of a single nuclear species, for example, the hydrogen nucleus, as measured by the spin-spin relaxation time, commonly denoted as $T_2$, and the spin-lattice relaxation time, commonly denoted as $T_1$, yields information about the chemical environment of that nuclear species. Such information may be used in classifying a substance. Moreover, the NMR response may also yield other parameters of the substance, including, but not limited to, the diffusion coefficient of a liquid and, in some cases, chemical shift information, that may be used to classify the substance.

Another known resonance classification system is a nuclear quadrupole resonance (NQR) system. Known NQR systems are related to the NMR systems described above. The NQR system is used to detect atoms having nuclei with a nuclear quadrupole moment. Unlike NMR systems, at least some known NQR systems perform inspections in an environment without a static or DC magnetic field. At least one known NQR system includes a radio frequency (RF) power source, a coil to produce a magnetic RF excitation field, and a detector circuit to detect a RF NQR response being emitted from a component of an object and/or substance. The NQR response is generated by the interaction of a quadrupolar charge distribution within the object and/or substance with an electric field gradient supplied by a nonuniform distribution of electron density (from bonding electrons). Compared to the chemical shift measured in NMR, the interaction is much larger; however, the response averages to zero in a liquid phase.

At least some known NMR and/or QNR systems detect whether a material is a metal or non-metal material; however, benign substances, such as water, and hazardous substances, such as gasoline, may emit similar responses in such systems such that the hazardous substance is not distinguished from the benign substance by using only resonance classification systems.

BRIEF DESCRIPTION OF THE INVENTION

In one aspect, a method for classifying a substance is provided. The method includes transmitting an electromagnetic signal at the substance, measuring a portion of the electromagnetic signal reflected by the substance, determining a reflection coefficient of the substance using the measured portion of the electromagnetic signal, and outputting a classification of the substance based on the determined reflection coefficient.

In another aspect, a classification system is provided. The classification system includes a resonance classification system and an electromagnetic classification system including an antenna and a measurement device communicatively coupled to the antenna. The measurement device generates a signal representative of a measurement of a reflected signal. The classification system also includes a control system operatively coupled to the resonance classification system and the electromagnetic classification system. The control system is configured to output a classification of a substance based at least partially on a reflection coefficient determined using the signal generated by the measurement device.

In still another aspect, an electromagnetic classification system is provided. The electromagnetic classification system includes an antenna and a measurement device communicatively coupled to the antenna. The measurement device generates a signal representative of a measurement of a reflected signal. The electromagnetic classification system also includes a control system operatively coupled to the measurement device. The control system is configured to output a classification of a substance based at least partially on a reflection coefficient determined using the signal generated by the measurement device.

BRIEF DESCRIPTION OF THE DRAWINGS

Figures 1, 2, 3, and 4 show exemplary embodiments of the systems and method described herein.

Figure 1 is a schematic view of a known relationship between an actual antenna and an image antenna.

Figure 2 is a schematic view of an exemplary classification system.

Figure 3 is a schematic view of an exemplary electromagnetic classification system suitable for use with the classification system shown in Figure 2.

Figure 4 is a flowchart of an exemplary embodiment of a method for classifying a substance suitable for use with the classification system shown in Figure 2.

DETAILED DESCRIPTION OF THE INVENTION

The embodiments described herein provide systems and a method for classifying a substance. In one embodiment, an electromagnetic classification system transmits an electromagnetic signal at or towards an object including a substance therein. Using a signal reflected from the substance, the electromagnetic classification system identifies whether the substance includes an aqueous or non-aqueous mixture, such as a solution. As used herein, the term "aqueous solution" refers to a solution in which the solvent is water. A "solvent," as used herein, refers to a liquid that dissolves a solid, liquid, and/or gaseous substance to result in a solution. As used herein, the term "non-aqueous solution" refers to a solution having a solvent other than water. Examples of non-aqueous solutions include organic solutions, such as acetone, ethanol, methane, isopropanol, propane, alcohols, glycols, aromatic hydrocarbons, and aliphatic hydrocarbons, and/or inorganic solutions, such as liquid ammonia and sulfur dioxide. The substance within the object may be further identified using a resonance classification system to determine if the solution includes explosives, narcotics, weapons, and/or other contraband present within the object.

A technical effect of the systems and method described herein is to distinguish flammable liquids from non-flammable liquids. An embodiment of a method uses a reflection coefficient to facilitate classifying a substance as aqueous or non-aqueous. As used herein, the term "reflection coefficient" refers to a ratio of a reflected wave to an incident wave at a point of reflection. The ratio may be a ratio of the voltages, currents, intensities, and/or amplitudes corresponding to the reflected and incident waves at an antenna's input terminal. Embodiments of the systems and method described herein may be used to facilitate avoiding misclassification of benign liquids as volatile liquids, and vice versa, by discriminating between aqueous and non-aqueous mixtures. For example, as described above, a resonance classification system detects a first property of a material, such as whether the material is metallic or non-metallic. Further, by determining the reflection coefficient of the substance using electromagnetic signals, a benign substance, such as water, which may be indistinguishable from some hazardous substances, such as gasoline, using only resonance classification systems, is distinguished from a hazardous substance because the benign substance is aqueous and the hazardous substance is non-aqueous.

At least one embodiment of the present invention is described below in reference to its application in connection with and operation of a system for inspecting a substance. However, it should be apparent to those skilled in the art and guided by the teachings herein provided that the invention is likewise applicable to any suitable system for scanning objects including a substance including, without limitation, containers, people, cargo, crates, boxes, drums, baggage, containers, luggage, and suitcases, transported by water, land, and/or air, as well as other containers and/or objects.

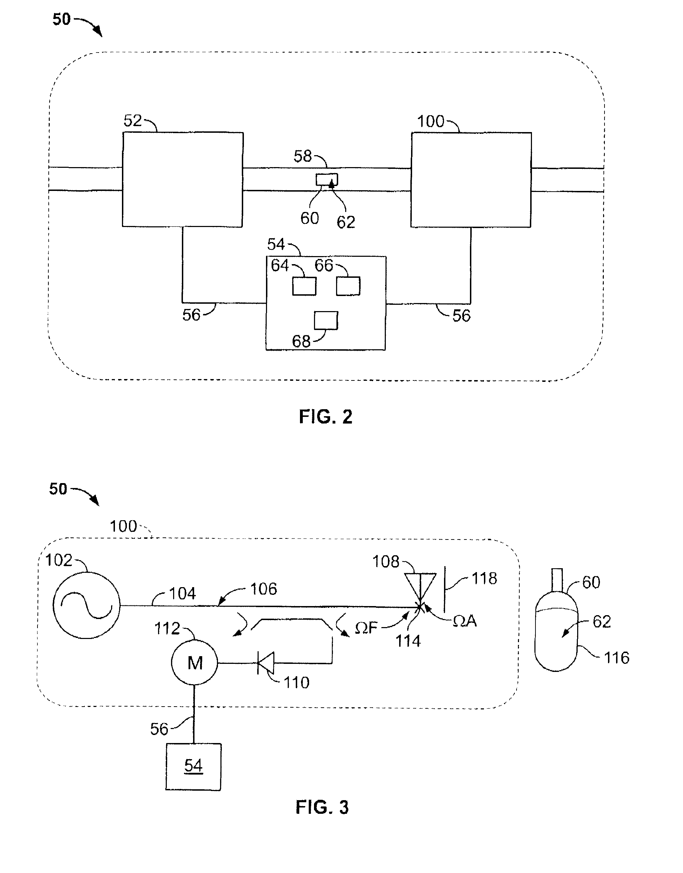

Figure 2 is a schematic view of an exemplary classification system 50. Figure 3 is a schematic view of an exemplary electromagnetic classification system 100 that may be used with classification system 50. In the exemplary embodiment, classification system 50 includes a resonance classification system 52, electromagnetic (EM) classification system 100, and a control system 54. More specifically, in the exemplary embodiment, resonance classification system 52 and EM classification system 100 are in communication with control system 54. A communication link 56 between these systems may be implemented using any suitable device, link, and/or method that supports the transfer of information, such as data, video, and/or image information. In the exemplary embodiment, the communication link 56 is implemented using conventional communication technologies such as unshielded twisted pair (UTP) wire, Ethernet, coaxial cables, and optical fibers. In an alternative embodiment, wireless communication technology is used, however, wireless communication technology may require a level of security to be used with certain classification applications. Further, a passage 58 extends between resonance classification system 52 and EM classification system 100 such that an object 60 including a substance 62 may be conveyed, transported, moved, directed, and/or transferred between systems 12 and 100. Examples of passage 58 include a walkway and/or a conveyor device. Alternatively, resonance classification system 52 and EM classification system 100 may be substantially co-located such that classification system 50 does not include passage 58.

In the exemplary embodiment, resonance classification system 52 is a magnetic resonance system or a quadrupole resonance system, as described above. Resonance classification system 52 may be positioned upstream r downstream of EM classification system 100. In the exemplary embodiment, EM classification system 100 includes a signal source 102, a transmission line 104, a directional coupler 106, an antenna 108, a detector 110, and a measurement device 112. In the exemplary embodiment, signal source 102 generates electromagnetic signals at a predetermined wavelength $\lambda$. More specifically, signal source 102 generates S-band and/or X-band signals at a fixed frequency. As used herein, the term "S-band" refers to an electromagnetic signal between about 2 GHz and about 4 GHz, and the term "X-band" refers to an electromagnetic signal between about 8 GHz and about 12 GHz. Further, in the exemplary embodiment, signal source 102 generates a steady state signal. As used herein, the term "steady state" refers to a signal that is in a substantially stable condition and that does not change with respect to time.

Transmission line 104 couples signal source 102 to antenna 108 for transmission of the signal generated by signal source 102 to antenna 108. Transmission line 104 is configured to transmit or guide radio-frequency energy between a first point and a second point. Transmission line 104 may be, for example, a wire, a two-wire line, a coaxial wire, and/or a hollow pipe or waveguide. In the exemplary embodiment, transmission line 104 is coupled to antenna 108 at a feedpoint 114, as described above. At feedpoint 114, transmission line 104 has a predetermined impedance $\Omega F$ in free space, as described above. The feedpoint impedance $\Omega F$ varies as antenna 108 is positioned with respect to a surface, such as a surface 116 of object 60 having substance 62 therein. More specifically, in the exemplary embodiment, the feedpoint impedance $\Omega F$ varies as antenna 108 is positioned with respect to a surface having a dielectric constant that is substantially different from the medium immediately surrounding antenna 108 and/or from a material that has a relatively high conductivity.

In the exemplary embodiment, antenna 108 is a dipole antenna, as described above. More specifically, antenna 108 is slightly shorter than the predetermined wavelength λ. For example, antenna 108 has a length λ/2, as described above. Further, in the exemplary embodiment, antenna 108 has an impedance ΩA such that, in free space, impedance ΩF is at resonance. Antenna 108 and transmission line 104 are matched such that resonance occurs when antenna 108 exhibits zero feedpoint reactance X. As used herein, the term "reactance" refers to the imaginary part of electrical impedance Z. In the exemplary embodiment, impedance ΩA is approximately equal to impedance ΩF (i.e., ΩF ≅ ΩA ≅ Ω) to achieve resonance in free space. Antenna 108 is configured to transmit the electromagnetic signal from signal source 102 at or towards object 60 and substance 62 therein, and to receive the electromagnetic signal reflected from substance 62. Further, EM classification system 100, in the exemplary embodiment, includes a conductive surface 118 spaced a predetermined distance from antenna 108. Conductive surface 118 facilitates achieving resonance and/or increasing the directionality of antenna 108. Moreover, in the exemplary embodiment, antenna 108 may be movable with respect to object 60 and/or stationary with respect to object 60. For example, antenna 108 and/or EM classification system 100 may be hand-held and movable with respect to a person, and/or may be stationary such that a container is moved pass antenna 108 and/or through EM classification system 100.

Directional coupler 106 is in communication with antenna 102 and samples a signal reflected from feedpoint 114 and/or a signal transmitted to feedpoint 114. In the exemplary embodiment, directional coupler 106 is coupled within transmission line 104. Directional coupler 106 is also in communication with detector 110. As such, directional coupler 106 is communicatively coupled between antenna 108 and detector 110, and between signal source 102 and antenna 108. Directional coupler 106 transmits the sampled signal(s) to detector 110, which converts the sampled signal to a direct current (DC) signal, for example.

In the exemplary embodiment, detector 110 is in communication with measurement device 112 to transmit the DC signal to measurement device 112. Further, in the exemplary embodiment, detector 110 functions as a diode to prevent current from flowing from measurement device 112 to directional coupler 106, transmission line 104, and/or antenna 108. Measurement device 112 receives the DC signal from detector 110 and converts the DC signal to human and/or machine readable form. In the exemplary embodiment, measurement device 112 measures a power reflected from substance 62 through antenna 108 and/or a phase of a signal reflected from substance 62 through antenna 108. Measurement device 112 is in communication with control system 54 such that control system 54 may further process the signal transmitted from measurement device 112.

In the exemplary embodiment, control system 54 includes, without limitation, one or more integrated circuit, a processor, a computer, a microcontroller, a microcomputer, a programmable logic controller, an application specific integrated circuit, and/or any other suitable components. As shown in Figure 2, control system 54 may also include a storage device 64, a display device 66, and/or an input device 68, such as a mouse and/or a keyboard. In the exemplary embodiment, display device 66, is, but is not limited to being, a monitor, a cathode ray tube (CRT), a liquid crystal display (LCD), and/or any other suitable output device that enables classification system 50 to function as described herein. In the exemplary embodiment, control system 54 is configured to control resonance classification system 52 and EM classification system 100. For example, control system 54 may instruct resonance classification system 52 and/or EM classification system 100 to perform a scan of object 60 and/or substance 62. In one embodiment, control system 54 activates and/or deactivates signal source 102. Further, control system 54 receives a signal from EM classification system 100, such as a signal representative of a measurement from measurement device 112 and/or a result from resonance classification system 52.

In the exemplary embodiment, control system 54 is configured to output a classification of substance 62 within object 60 based on a reflection coefficient determined using an output of measurement device 112, as described in more detail below. Classification of substance 62 may include, but is not limited to including, an indication whether substance 62 within object 60 is aqueous or non-aqueous, an indication of whether object 60 includes a metallic or a non-metallic material, an indication of a threat level of a material within object 60, an image of object 60, and/or any other suitable classification of substance 62 and/or object 60. Control system 54 is also configured to output a classification of substance 62 and/or object 60 using an output of measurement device 112 and an output of resonance classification system 52. Further, control system 54 is configured to determine an impedance caused by a signal reflected from substance 62, as described in more detail below.

Additionally, in the exemplary embodiment, the results of classification system 50 are output to a memory, such as storage device 64, a drive, a display device, such as display device 66, and/or any other suitable component. In alternative embodiments of classification system 50, one or more control systems 14 may be used to classify substance 62 within object 60.

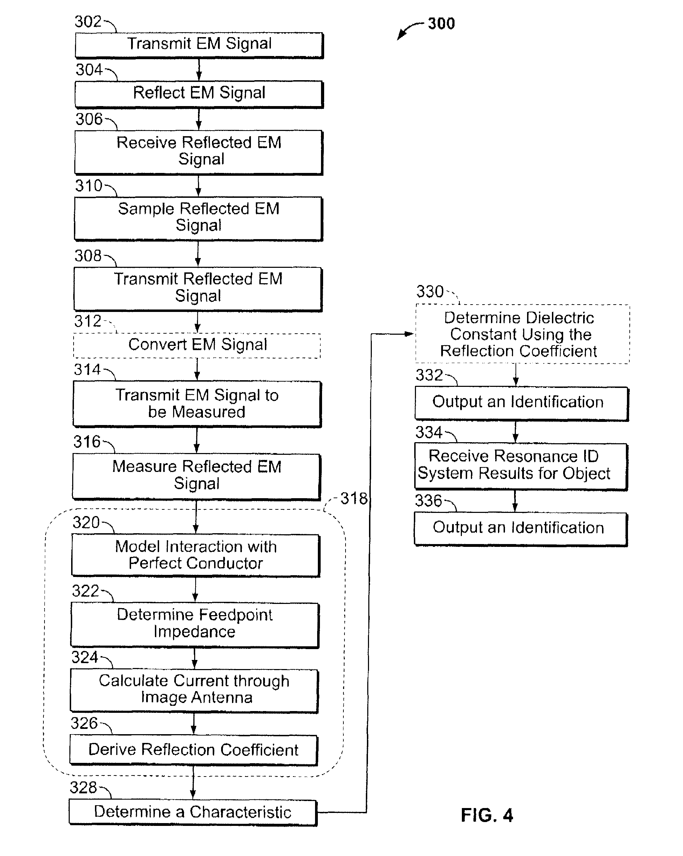

Figure 4 is a flowchart of an exemplary embodiment of a method 300 for classifying a substance within an object, such as substance 62 within object 60 (shown in Figures 2 and 3). Method 300 may be used with classification system 50 (shown in Figures 2 and 3). In the exemplary embodiment, method 300 is implemented on system 50 and/or system 100, however, method 300 is not limited to implementation on system 50 and/or system 100. Rather, method 300 may be embodied on a computer readable medium as a computer program and/or implemented and/or embodied by any other suitable means. The computer program may include a code segment that, when executed by a processor, configures the processor to perform one or more of the functions of method 300.

Method 300 includes transmitting 302 an electromagnetic signal at or towards substance 62. More specifically, in the exemplary embodiment, an S-band and/or an X-band signal is transmitted 302 at or towards the substance using an antenna, such as antenna 108 (shown in Figure 3), coupled to a transmission line, such as transmission line 104. The electromagnetic signal is reflected 304 by the substance, and at least a portion of the reflected signal is received 306 by the antenna. The received signal is transmitted 308 to a detector, such as detector 110 (shown in Figure 3) via a line, such as directional coupler 106 (shown in Figure 3). More specifically, in the exemplary embodiment, directional coupler 106 samples 310 the reflected signal at a feedpoint, such as feedpoint 114, and transmits 308 the sampled signal to detector 110. Detector 110, in the exemplary embodiment, optionally converts 312 the transmitted signal to a direct current signal. Further, in the exemplary embodiment, the converted signal is transmitted 314 by detector to a measuring device, such as measuring device 112 (shown in Figure 2). In the exemplary embodiment, method 300 includes measuring 316 a portion of the electromagnetic signal that is reflected by object 60 and transmitted 314 to measuring device 112. For example, measuring device 112 measures 316 a power and/or a phase of the reflected signal.

Method 300 also includes determining 318 a reflection coefficient of substance 62 using the measured portion of the electromagnetic signal. More specifically, in the exemplary embodiment, the reflection coefficient is determined 318 by modeling 320 the interaction between the antenna and flat surface that is a perfect conductor by assuming an image antenna is spaced distance $d$ from an opposite side of the perfect conductor as the antenna, as described above and shown in Figure 1. The current $I_{image}$ flowing in the image antenna is equal and opposite the current $I_{acual}$ of the actual antenna. The impedance at the feedpoint of the actual antenna is determined 322 using:

$$Z_{feedpoint} = Z_{self} + Z_{mutual} * (I_{image}/I_{actual}), \qquad \text{Eq. (1)}$$

where $Z_{feedpoint}$ is the impedance at the feedpoint of the actual antenna, $Z_{self}$ is the impedance between the antenna and itself, and $Z_{mutual}$ is the impedance induced between the image antenna and the actual antenna. Since $I_{image}$ = - $I_{actual}$, $Z_{feedpoint}$ = $Z_{self}$ - $Z_{mutual}$. As such, when the spacing between the image antenna and the actual antenna is approximately equal to zero, $Z_{mutual}$ approaches $Z_{self}$ and $Z_{feedpoint}$ is approximately equal to zero.

When the flat surface is a non-perfect conductor, the image current $I_{image}$ is calculated 324 using:

$$I_{image} = I_{actual} * \Gamma, \qquad \text{Eq. (2)}$$

where $\Gamma$ is the reflection coefficient. The reflection coefficient approaches unity when either the dielectric constant $\varepsilon$ of the non-perfect conductor becomes large (i.e., $\varepsilon >> 1$), or the conductivity of the non-perfect conductor is sufficiently high that the skin depth is small compared to a wavelength. As used herein, the term "dielectric constant" refers to a measure of the ability of a material to store electrical energy, and the term "skin depth" refers to a measure of the distance needed for a current to decrease to 1/e of its original value, where e is the known mathmatical constant. Conversely, if the conductivity of the non-perfect conductor is low enough (i.e., meets the criteria for a good dielectric) and the non-perfect conductor has a low dielectric constant, then the reflection coefficient $\Gamma$ will approach zero, giving the equation:

$$\Gamma = -\left|\frac{\sqrt{\varepsilon} - 1}{\sqrt{\varepsilon} + 1}\right|, \qquad \text{Eq. (3)}$$

in which case the antenna acts as if it were in free space.

Further, if the resistance of the antenna $\Omega A$ is matched to the resistance of the transmission line $\Omega F$ such that resistance $\Omega A$ is approximately equal to resistance $\Omega F$ (i.e. $\Omega F \cong \Omega A \cong \Omega$) to achieve resonance in free space, as described above, and the change in $Z_{feedpoint}$ is known, the reflection coefficient of the antenna $\Gamma_{feedpoint}$ can be derived 326 using:

$$\Gamma_{feedpo\,int} = \left| \frac{Z_{feedpo\,int} - \Omega}{Z_{feedpo\,int} + \Omega} \right| .$$

Using the above-described calculations, the reflection coefficient of a material, such as the non-perfect conductor, can be determined 318. The above-described calculations are one example of determining 318 the reflection coefficient of the substance by determining 322 an impedance caused by the measured portion of the electromagnetic signal reflected from the substance. The reflection coefficient is used to determine 328 a characteristic of the substance, for example, whether the substance is aqueous or non-aqueous. For example, water has a reflection coefficient of about -1 normal to its surface, and accordingly, has a dielectric constant of about 80 at frequencies lower than approximately 20 GHz. In contrast, a petroleum product generally has a reflection coefficient of -0.16 normal to its surface of approximately and a dielectric constant of approximately 2 at frequencies lower than approximately 20 GHz. As such, water can be distinguished from other substances, such as petroleum products, using the reflection coefficient of the substance being classified, scanned, and/or tested.

More specifically, by determining 318 the reflection coefficient of the material, a dielectric constant of the material may optionally be determined 330 using a suitable relationship between the reflection coefficient and the dielectric constant. A classification of substance 62 within object 60 based on the determined reflection coefficient is then output 332 to a memory, such as memory 64 (shown in Figure 2), a drive, a display device, such as display device 66 (shown in Figure 2), and/or any other suitable component. A classification of substance 62 and/or object 60 may include, for example, an indication whether the substance is aqueous or non-aqueous, an indication of whether object 60 includes a metallic or a non-metallic substance, an indication of a threat level of substance 62, an image of object 60, and/or any other suitable classification of substance 62 and/or object 60. In the exemplary embodiment, method 300 also includes receiving 334 a result, such as a signal representative of a material characteristic, a signal representative of atoms in object 60, a signal representative of a chemical element that has a magnetic dipole moment, of a resonance classification system, such as resonance classification system 52 (shown in Figure 2). An identifcation of a characteristic of object 60 and/or substance 62, such as the threat level of a non-metallic substance and/or any other suitable characteristic of substance 62, is output 336 using the determined reflection coefficient and the result received 334 from resonance classification system 52. In one embodiment, resonance classification system 52 determines, for example, but is not limited to determining, if substance 62 is a metallic or non-metallic material, and the reflection coefficient is used to determined if substance 62 is flammable or non-flammable. If substance 62 is flammable, the threat level is increased, as compared to when substance 62 is non-flammable. Further, in one embodiment, outputting 332 and/or 336 a classification of substance 62 includes outputting the determined dielectric constant of substance 62.

By using the above-described method and systems a relatively benign substance may be distinguished from a relatively volatile substance. For example, by using both a resonance classification system and an EM classification system, a relatively benign liquid, such as vegetable oil, may be classified as such. More specifically vegetable oil has a relatively low dielectric constant. Vegetable oil may be flammable but, because it has a low vapor pressure, vegetable oil is at a low hazard level. However, vegetable oil is also characterized by a relatively high viscosity, and will be determined to be benign by using both the resonance classification system and the EM classification system. Further, by using the EM classification system in conjunction with the resonance classification system, the classification is facilitated to be more robust, as compared to using either classification alone. In addition, the above described classification system enable the dielectric measurement to be simplified, as compared to known systems that use electromagnetic signals for classification. For example, the classification using the above-described classification system is less likely to be influenced by bottle characteristics, and the design of the antenna can be simplified to facilitate lowering the cost of implementation, as compared to known systems that use electromagnetic signals for classification.

Exemplary embodiments of systems and a method for classifying a substance are described above in detail. The systems and method are not limited to the specific embodiments described herein. For example, the method may also be used in combination with other classification systems and/or classification methods, and is not limited to practice with only the classification systems as described herein.

Although specific features of various embodiments of the invention may be shown in some drawings and not in others, this is for convenience only. In accordance with the principles of the invention, any feature of a drawing may be referenced and/or claimed in combination with any feature of any other drawing.

While various embodiments of the invention have been described, those skilled in the art will recognize that modifications of these various embodiments of the invention can be practiced within the spirit and scope of the claims.

Aspects of the present invention are defined in the following numbered clauses:

    1. A method for classifying a substance, said method comprising:

transmitting an electromagnetic signal at the substance;

measuring a portion of the electromagnetic signal reflected by the substance;

determining a reflection coefficient of the substance using the measured portion of the electromagnetic signal; and

outputting a classification of the substance based on the determined reflection coefficient.

2. A method in accordance with Clause 1, wherein transmitting an electromagnetic signal at the substance further comprises transmitting at least one of an S-band signal and an X-band signal at the substance.

3. A method in accordance with Clause 1, wherein measuring a portion of the electromagnetic signal reflected by the substance further comprises measuring a power of the portion of the electromagnetic signal reflected by the substance.

4. A method in accordance with Clause 1, wherein measuring a portion of the electromagnetic signal reflected by the substance further comprises measuring a phase of the portion of the electromagnetic signal reflected by the substance.

5. A method in accordance with Clause 1, wherein determining a reflection coefficient of the substance further comprises determining an impedance caused by the measured portion of the electromagnetic signal.

6. A method in accordance with Clause 1, wherein outputting a classification of the substance further comprises determining a dielectric constant of the substance using the determined reflection coefficient.

7. A method in accordance with Clause 1, wherein outputting a classification of the substance further comprises classifying the substance using the determined reflection coefficient and a result from a magnetic resonance classification device.

8. A classification system, comprising:

a resonance classification system;

an electromagnetic classification system comprising an antenna and a measurement device communicatively coupled to said antenna, said measurement device generating a signal representative of a measurement of a reflected electromagnetic signal; and

a control system operatively coupled to said resonance classification system and said electromagnetic classification system, said control system configured to output a classification of a substance based at least partially on a reflection coefficient determined using said signal generated by said measurement device.

9. A classification system in accordance with Clause 8, wherein said control system is configured to output the classification of said substance using said signal generated by said measurement device and a result of said resonance classification system.

10. A classification system in accordance with Clause 8, further comprising a directional coupler communicatively coupled between said antenna and a signal source, said signal source generating an electromagnetic signal that is transmitted by said antenna.

11. A classification system in accordance with Clause 10, wherein said signal source produces at least one of an S-band signal and an X-band signal.

12. A classification system in accordance with Clause 8, further comprising a detector coupled between said measurement device and said antenna.

13. A classification system in accordance with Clause 8, wherein said electromagnetic classification system further comprises a conducting surface coupled at a distance from said antenna.

14. A classification system in accordance with Clause 8, wherein said measurement device is configured to measure a power reflected from said substance and generate a signal representative of the power reflected.

15. A classification system in accordance with Clause 8, wherein said antenna is stationary with respect to said substance.

16. A classification system in accordance with Clause 8, wherein said antenna is movable with respect to said substance.

17. An electromagnetic classification system, comprising:

an antenna;

a measurement device communicatively coupled to said antenna, said measurement device generating a signal representative of a measurement of a reflected electromagnetic signal; and

a control system operatively coupled to said measurement device, said control system configured to output a classification of a substance based at least partially on a reflection coefficient determined using said signal generated by said measurement device.

18. An electromagnetic classification system in accordance with Clause 17, further comprising a directional coupler communicatively coupled between said antenna and a signal source, said signal source generating an electromagnetic signal that is transmitted by said antenna, wherein said signal source produces at least one of an S-band signal and an X-band signal.

19. An electromagnetic classification system in accordance with Clause 17, wherein said measurement device is configured to measure at least one of a power reflected from said substance and a phase of a signal reflected from said substance and generate a signal representative of at least one of a measurement of power and a measurement of phase.

20. An electromagnetic classification system in accordance with Clause 17, wherein said control system is configured to determine an impedance caused by a signal reflected from said substance.

## Claims

1. A classification system (50), comprising:

   a resonance classification system (52);
   an electromagnetic classification system (100) comprising an antenna (10) and a measurement device (112) communicatively coupled to said antenna, said measurement device generating a signal representative of a measurement of a reflected electromagnetic signal; and
   a control system (54) operatively coupled to said resonance classification system and said electromagnetic classification system, said control system configured to output a classification of a substance based at least partially on a reflection coefficient determined using said signal generated by said measurement device.

2. A classification system (50) in accordance with Claim 1, wherein said control system (54) is configured to output the classification of said substance using said signal generated by said measurement device (112) and a result of said resonance classification system (52).

3. A classification system (50) in accordance with Claim 1 or Claim 2, further comprising a directional coupler (106) communicatively coupled between said antenna (10) and a signal source (102), said signal source generating an electromagnetic signal that is transmitted by said antenna.

4. A classification system (50) in accordance with Claim 3, wherein said signal source (102) produces at least one of an S-band signal and an X-band signal.

5. A classification system (50) in accordance with any one of the preceding Claims, further comprising a detector (110) coupled between said measurement device (112) and said antenna.

6. A classification system (50) in accordance with any one of the preceding Claims, wherein said electromagnetic classification system (100) further comprises a conducting surface (118) coupled at a distance from said antenna (10).

7. A classification system (50) in accordance with any one of the preceding Claims, wherein said measurement device (112) is configured to measure a power reflected from said substance and generate a signal representative of the power reflected.

8. A classification system (50) in accordance with any one of the preceding Claims, wherein said antenna (10) is stationary with respect to said substance.

9. A classification system (50) in accordance with any one of the preceding Claims, wherein said antenna (10) is movable with respect to said substance.

10. An electromagnetic classification system, comprising:

an antenna (10);
a measurement device (112) communicatively coupled to said antenna, said measurement device generating a signal representative of a measurement of a reflected electromagnetic signal; and
a control system (54) operatively coupled to said measurement device, said control system configured to output a classification of a substance based at least partially on a reflection coefficient determined using said signal generated by said measurement device.

FIG. 1
(Prior Art)

50

**FIG. 2**

50

**FIG. 3**

302 — Transmit EM Signal

300

304 — Reflect EM Signal

306 — Receive Reflected EM Signal

310 — Sample Reflected EM Signal

308 — Transmit Reflected EM Signal

312 — Convert EM Signal

314 — Transmit EM Signal to be Measured

316 — Measure Reflected EM Signal

318

320 — Model Interaction with Perfect Conductor

322 — Determine Feedpoint Impedance

324 — Calculate Current through Image Antenna

326 — Derive Reflection Coefficient

328 — Determine a Characteristic

330 — Determine Dielectric Constant Using the Reflection Coefficient

332 — Output an Identification

334 — Receive Resonance ID System Results for Object

336 — Output an Identification

FIG. 4

Europäisches
Patentamt
European
Patent Office
Office européen
des brevets

## EUROPEAN SEARCH REPORT

Application Number

EP 08 17 2081

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/235658 A1 (ZIMDARS DAVID A [US] ET AL) 11 October 2007 (2007-10-11) * paragraphs [0006], [0007], [0034], [0044], [0066] * | 1,2,6-10 | INV. G01N24/08 G01R33/44 G01N22/00 G01V3/14 |
| Y | GB 2 425 842 A (PLANT BIOSCIENCE LTD [GB]) 8 November 2006 (2006-11-08) * page 13, line 11 - line 25 * * page 22, line 21 - line 28; claims 23,24,30,32,37 * | 1-10 | |
| Y | TAMYIS N ET AL: "Free space measurement of complex permittivity and complex permeability of magnetic materials using open circuit and short circuit method at microwave frequencies" RESEARCH AND DEVELOPMENT, 2002. SCORED 2002. STUDENT CONFERENCE ON JUL 16-17, 2002, PISCATAWAY, NJ, USA,IEEE, 16 July 2002 (2002-07-16), pages 394-398, XP010603555 ISBN: 978-0-7803-7565-9 * page 394; figure 1 * | 1-10 | |
| X | AL-MATTARNEH H M A ET AL: "Microwave nondestructive testing for classification of malaysian timber using free-space techniques" SIGNAL PROCESSING AND ITS APPICATIONS, SIXTH INTERNATIONAL, SYMPOSIUM ON. 2001 AUG. 16-16, 2001, PISCATAWAY, NJ, USA,IEEE, vol. 2, 16 August 2001 (2001-08-16), pages 450-453, XP010557084 ISBN: 978-0-7803-6703-6 * the whole document * | 10 | TECHNICAL FIELDS SEARCHED (IPC) G01R G01N G01V |

-/--

The present search report has been drawn up for all claims

| Place of search | Date of completion of the search | Examiner |
|---|---|---|
| Munich | 15 April 2009 | Skalla, Jörg |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

# EUROPEAN SEARCH REPORT

**Application Number**

EP 08 17 2081

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/132127 A1 (FULLERTON LARRY W [US]) 22 June 2006 (2006-06-22) * paragraphs [0006], [0015], [0029], [0031], [0032], [0041], [0042]; claim 19 * | 1-10 | |
| Y | THIESAN L. ET AL: "Survey of Commercially Available Explosives Detection Technologies and Equipment 2004" [Online] 1 September 2006 (2006-09-01), pages 1-96, XP002523686 Retrieved from the Internet: URL:http://web.archive.org/web/20060901180 219/http://www.ncjrs.gov/pdffiles1/nij/gra nts/208861.pdf> [retrieved on 2009-04-15] * page 60 - page 62 * | 1-10 | |
| Y | WO 2005/038978 A (SPATIAL DYNAMICS LTD [US]) 28 April 2005 (2005-04-28) * page 3, line 14 - line 25 * | 1-10 | |
| A | EP 0 426 851 A (HITACHI LTD [JP]) 15 May 1991 (1991-05-15) * column 1, line 35 - line 41 * * column 21, line 29 - line 45 * | 1,10 | **TECHNICAL FIELDS SEARCHED (IPC)** |
| A | US 2005/032233 A1 (GOPALSAMI NACHAPPA [US] ET AL) 10 February 2005 (2005-02-10) * paragraphs [0003], [0005], [0017], [0018]; claim 1 * | 1-10 | |

The present search report has been drawn up for all claims

| Place of search | Date of completion of the search | Examiner |
|---|---|---|
| Munich | 15 April 2009 | Skalla, Jörg |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 08 17 2081

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2009

| Patent document cited in search report | | Publication date | Patent family member(s) | | Publication date |
|---|---|---|---|---|---|
| US 2007235658 | A1 | 11-10-2007 | NONE | | |
| GB 2425842 | A | 08-11-2006 | EP | 1877817 A2 | 16-01-2008 |
| | | | WO | 2006117520 A2 | 09-11-2006 |
| US 2006132127 | A1 | 22-06-2006 | US | 2009085565 A1 | 02-04-2009 |
| | | | US | 2007222448 A1 | 27-09-2007 |
| WO 2005038978 | A | 28-04-2005 | AU | 2004306870 A1 | 28-04-2005 |
| | | | BR | PI0415413 A | 05-12-2006 |
| | | | CA | 2542842 A1 | 28-04-2005 |
| | | | CN | 1868091 A | 22-11-2006 |
| | | | EP | 1676335 A2 | 05-07-2006 |
| | | | JP | 2007508570 T | 05-04-2007 |
| | | | KR | 20060096050 A | 05-09-2006 |
| EP 0426851 | A | 15-05-1991 | DE | 68927612 D1 | 13-02-1997 |
| | | | DE | 68927612 T2 | 31-07-1997 |
| | | | WO | 9004169 A1 | 19-04-1990 |
| | | | US | 5168224 A | 01-12-1992 |
| US 2005032233 | A1 | 10-02-2005 | NONE | | |

EPO FORM P0459

For more details about this annex : see Official Journal of the European Patent Office, No. 12/82